# FASCICULE DE BREVET EUROPEEN

(11) **EP 3 769 964 B1**
(45) Date de publication et mention de la délivrance du brevet: **21.06.2023**
(21) Numéro de dépôt: 20186141.6
(22) Date de dépôt: 16.07.2020
(51) Int. Cl.: B33Y 70/10, B29C 64/165, C08F 2/48, C08F 222/10, C04B 35/111, C04B 35/26, C04B 35/486, C04B 35/565, C04B 35/581, C04B 35/584

(54) **PROCÉDÉ DE FABRICATION, PAR STÉRÉOLITHOGRAPHIE, DE PIÈCES CRUES EN MATÉRIAU CÉRAMIQUE OU MÉTALLIQUE PAR VOIE PHOTO-THERMIQUE**
VERFAHREN ZUR HERSTELLUNG DURCH STEREOLITHOGRAPHIE VON KERAMISCHEN ODER METALLISCHEN GRÜNKÖRPERN AUF FOTOTHERMISCHEM WEG
METHOD FOR MANUFACTURING, BY STEREOLITHOGRAPHY, GREEN CERAMIC OR METAL MATERIAL PARTS BY PHOTO-THERMAL PROCEDURE

(30) Priorité: 22.07.2019 FR 1908279
(43) Date de publication de la demande: 27.01.2021
(73) Titulaire: S.A.S 3DCeram-Sinto, 87280 Limoges (FR)
(72) Inventeur: CHAPUT, Christophe, 87410 Le-Palais-sur-Vienne (FR); GAIGNON, Richard, 91770 Saint-Vrain (FR); SCHICK, Cindy, 87410 Le-Palais-sur-Vienne (FR)
(74) Mandataire: Cabinet Chaillot

(56) Documents cités:
- EP-A2- 1 524 049
- CN-A- 108 558 372
- FR-A1- 3 028 851

## Description

La présente invention concerne un procédé et une composition pour la fabrication de pièces crues en matière céramique ou métallique par stéréolithographie, de telles pièces crues étant destinées à être soumises à des opérations de nettoyage, déliantage et frittage pour obtenir des pièces céramiques ou métalliques finies.

La stéréolithographie comprend généralement les étapes suivantes, pour l'obtention de ces pièces crues :
- on construit, par conception assistée par ordinateur, un modèle informatique de la pièce à fabriquer, modèle dont les dimensions sont légèrement plus grandes que celles de la pièce à fabriquer afin de prévoir un retrait du matériau céramique ou métallique au cours de la fabrication de la pièce ; et
- on fabrique la pièce de la façon suivante :
   - on forme, sur un support rigide, une première couche d'une composition photodurcissable comprenant au moins une matière céramique ou métallique, un monomère et/ou oligomère photodurcissable, un photoinitiateur et le cas échéant au moins l'un parmi un plastifiant, un solvant, un dispersant et un inhibiteur de polymérisation ;
   - on fait durcir la première couche de la composition photodurcissable par irradiation (par balayage laser de la surface libre de ladite couche ou par système de projection à diodes) selon un motif défini à partir du modèle pour ladite couche, formant un premier étage ;
   - on forme, sur le premier étage, une seconde couche de la composition photodurcissable ;
   - on fait durcir la seconde couche de la composition photodurcissable, par irradiation selon un motif défini pour ladite couche, formant un deuxième étage, cette irradiation s'effectuant comme pour la première couche ;
   - optionnellement, on répète les étapes ci-dessus pour obtenir la pièce à l'état cru.

Ensuite, comme indiqué ci-dessus, pour obtenir la pièce finie, on nettoie la pièce à l'état cru pour enlever la composition non durcie ; on déliante la pièce à l'état cru nettoyée ; et on fritte la pièce à l'état cru nettoyée et déliantée pour obtenir la pièce finie.

On peut fabriquer la pièce par voie pâteuse ou par voie liquide.
- Dans une fabrication par voie pâteuse, la composition photodurcissable se présente sous la forme d'une pâte et le support rigide est une plate-forme de travail supportant les différentes couches de la pièce en cours de construction ainsi que la pâte et l'on forme généralement chacune des couches par abaissement de la plate-forme de travail et étalement d'une épaisseur de pâte prédéfinie. Une réserve de pâte est stockée dans des réservoirs qui sont automatiquement vidés d'une quantité de pâte prédéfinie à chaque couche à l'aide d'un piston. Cela crée un bourrelet de pâte à étaler sur la couche supérieure de la pièce en cours de fabrication qui aura été abaissée auparavant par la plate-forme de travail. Chaque couche est généralement étalée par raclage par une lame de raclage qui balaye la surface de travail de la plate-forme de travail, par exemple en avançant suivant une direction horizontale rectiligne.
- Dans une fabrication par voie liquide, la composition photodurcissable se présente sous la forme d'une suspension de faible viscosité.

- Dans un premier mode de réalisation par la voie liquide, le support rigide est une plate-forme que l'on fait descendre dans un bain de la suspension photodurcissable pour la recouvrir d'une couche de ladite suspension, couche que l'on fait ensuite durcir par irradiation comme indiqué ci-dessus. Sur cette première couche, on forme ensuite successivement chacune des autres couches par abaissement pas à pas de la plate-forme dans le bain de telle sorte que l'étage supérieur de la pièce en cours de formation soit abaissé sous la surface libre de la suspension photodurcissable pour la formation de la couche en question, laquelle est ensuite irradiée.
- Dans un deuxième mode de réalisation par la voie liquide, la suspension photodurcissable est contenue dans un réservoir à fond transparent pour l'irradiation, et la pièce est maintenue sur un support rigide qui est une plate-forme remontée pas à pas. Ainsi, on commence par faire durcir une couche de fond, puis la plate-forme est remontée d'un pas pour permettre à la suspension de constituer une nouvelle couche que l'on fait alors durcir, l'opération étant répétée à chaque couche.
- Dans un troisième mode de réalisation par la voie liquide, la suspension photodurcissable est étalée en couche sur un film transparent pour l'irradiation, le film étant apte à se dérouler horizontalement. La pièce est formée sur une plate-forme rigide qui descend pour venir en contact avec la couche que l'on fait durcir par irradiation à travers le film. On déroule ensuite un nouveau segment de film revêtu d'une nouvelle couche photodurcissable et on réitère l'opération jusqu'à la fin de la construction de la pièce.

Les différentes poudres céramiques ou métalliques que l'on utilise en stéréolithographie présentent des comportements d'absorption de la lumière UV à la longueur d'onde du faisceau UV utilisé (355nm) qui sont variables de l'une à l'autre.

Certaines poudres sont très absorbantes, comme c'est le cas d'une poudre de céramique lanthane strontium manganite (LSM), de carbure de silicium (SiC) ou d'argent (Ag), et d'autres le sont beaucoup moins, comme l'alumine (Al₂O₃) et la zircone (ZrO₂).

On peut ainsi mentionner que la poudre de ZrO₂ absorbe seulement 8% de la lumière UV à 355 nm, alors que LSM et SiC en absorbent chacun plus de 90%.

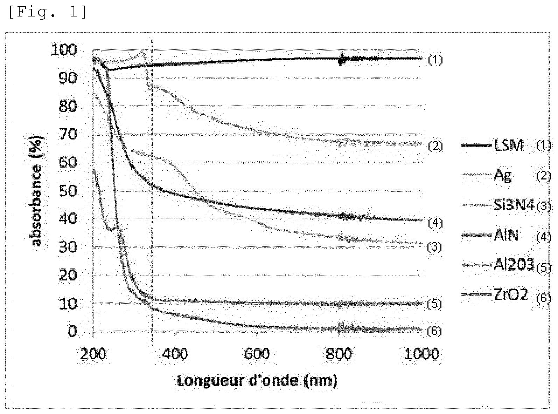

[Fig. 1] donne les spectres d'absorption de certaines poudres céramiques / métalliques.

Dans ces derniers cas, la lumière absorbée par la poudre n'est plus disponible pour le photoamorceur et la réaction de photopolymérisation ne peut donc plus avoir lieu.

En d'autres termes, le manque de réactivité de certaines pâtes ou suspensions céramiques ou métalliques photosensibles sous insolation UV rend difficile, voire impossible, la construction d'un objet par stéréolithographie UV.

Pour résoudre ce problème, la Société déposante a incorporé un amorceur thermique dans une pâte ou suspension céramique ou métallique dans le but d'utiliser l'énergie thermique libérée par les poudres céramiques ou métalliques lors de leur insolation par une lumière aussi bien UV-visible qu'IR pour générer l'amorçage contrôlé de la polymérisation thermique.

Dans ce cas, l'absorbance des particules céramiques ou métalliques à la longueur d'onde de travail est donc favorable puisque l'énergie lumineuse absorbée par les particules céramiques ou métalliques est convertie en chaleur et que cette chaleur est ensuite absorbée par un amorceur thermique qui permet la polymérisation de la résine.

A cet effet, la présente invention porte sur un procédé de fabrication, par stéréolithographie, d'une pièce crue en un matériau céramique ou métallique, procédé suivant lequel des couches à base d'une composition durcissable comprenant :
- ledit matériau céramique ou métallique formé par au moins une poudre respectivement céramique ou métallique ; et
- une partie organique comprenant au moins un monomère et/ou un oligomère et au moins un amorceur de la polymérisation dudit ou desdits monomères et/ou oligomères,

sont amenées successivement à durcir par ladite polymérisation selon un motif défini pour chaque couche, la première couche étant formée sur une plate-forme de construction, et chaque autre couche étant formée puis amenée à durcir sur la couche précédente,
caractérisé par le fait que l'on utilise, comme amorceur(s), au moins un amorceur thermique, lequel est apte à générer l'amorçage d'une polymérisation thermique sous l'action de l'énergie thermique libérée par ledit matériau respectivement céramique ou métallique lors d'une insolation de celui-ci par au moins une source d'irradiation choisie parmi les sources d'irradiation UV, visible ou IR;
la ou les poudres céramiques étant choisies parmi la céramique lanthane strontium manganite, la céramique lanthane strontium manganite en mélange avec de la zircone stabilisée par l'yttrium, la ferrite, le carbure de silicium et le nitrure de silicium, et la ou les poudres métalliques étant choisies parmi l'argent, le cuivre, le fer, le tungstène et leurs alliages.

On peut utiliser la ou les poudres céramiques et/ou métalliques à raison notamment de 25 à 65 parties en volume par rapport au volume total.

Comme monomères et/ou oligomères entrant dans la partie organique de la composition durcissable selon l'invention, on peut citer les (méth)acrylates polyfonctionnels, comme le diméthacrylate de bisphénol A diéthoxylé, le diacrylate de 1,6-hexanediol, le diacrylate de 3-méthyl-1,5-pentanediol, le triacrylate de triméthylolpropane et leurs mélanges.

On peut utiliser le ou les monomères et/ou oligomères à raison notamment de 20 à 50 parties en volume par rapport au volume total.

On peut choisir le ou les amorceurs thermiques parmi :
- les peroxydes, tels que le peroxybenzoate de tert-amyle, le peroxyde de benzoyle, le 2,2-bis(tert-butylperoxy)butane, le 1,1-bis(tert-butylperoxy)cyclohexane, le 2,5-bis(tert-butylperoxy)-2,5-diméthylhexane, le 2,5-bis(tert-butylperoxy)-2,5-diméthyl-3-hexyne, le bis(1-(tert-butylperoxy)-1-méthyl éthyl)benzène, le 1,1-bis(tert-butylperoxy)-3,3,5-triméthylcyclohexane, le peracétate de tert-butyle, le peroxyde de tert-butyle, le peroxybenzoate de tert-butyle, le carbonate de tert-butylperoxy isopropyle, le peroxyde de cyclohexanone, le peroxyde de dicumyle, le peroxyde de lauroyle, le peroxyde de 2,4-pentanedione, le persulfate de potassium et le persulfate d'ammonium;
- les hydroperoxydes tels que l'hydroperoxyde de tert-butyle, l'hydroperoxyde de cumène, l'acide peracétique ;
- les alcoxyamines telles que la N-(2-méthylpropyl)-N-(1-diéthylphosphono-2,2-diméthylpropyl)-O-(2-carboxyprop-2-yl)hydroxylamine (blocbuilder MA) ; et
- les composés azo, tels que le 1,1'-azobis (cyclohexanecarbonitrile) et le 2,2'-azobisisobutyronitrile (AIBN).

On peut utiliser le ou les amorceurs thermiques à raison notamment de 0,5 à 8 parties en volume par rapport au volume total.

On peut également utiliser une composition durcissable comprenant en outre au moins un plastifiant choisi notamment parmi le polyéthylène glycol, le phtalate de dibutyle et le glycérol (liste non exhaustive), à raison notamment de 5 à 25 parties en volume par rapport au volume total.

On peut également utiliser une composition durcissable comprenant en outre au moins un dispersant choisi notamment parmi les esters phosphoriques, à raison notamment de 1 à 8 parties en volume par rapport au volume total.

On peut également utiliser en particulier une composition durcissable comprenant en outre au moins un inhibiteur de polymérisation choisi notamment parmi le 4-méthoxyphénol et la phénothiazine, à raison notamment de 0,1 à 3 parties en volume par rapport au volume total.

La présente invention porte également sur une composition pour la mise en oeuvre du procédé tel que défini ci-dessus caractérisée par le fait qu'elle comporte :
- une ou des poudres céramiques et/ou métalliques ;
- un ou des monomères et/ou oligomères, et
- au moins un amorceur thermique, apte à générer l'amorçage d'une polymérisation thermique sous l'action de l'énergie thermique libérée par ledit matériau respectivement céramique ou métallique lors d'une insolation de celui-ci par au moins une source d'irradiation choisie parmi les sources d'irradiation UV, visible ou IR ; la
ou les poudres céramiques étant choisies parmi la céramique lanthane strontium manganite, la céramique lanthane strontium manganite en mélange avec de la zircone stabilisée par l'yttrium, la ferrite et les poudres céramiques non oxydes, telles que le carbure de silicium et le nitrure de silicium, et la ou les poudres métalliques étant choisies parmi l'argent, le cuivre, le fer, le tungstène et leurs alliages, et la ou les poudres céramiques et/ou métalliques peuvent être présentes à raison notamment 25 à 65 parties en volume par rapport au volume total de la composition.

Le ou les monomères et/ou oligomères peuvent être choisis parmi les (méth)acrylates polyfonctionnels, comme le diméthacrylate de bisphénol A diéthoxylé, le diacrylate de 1,6-hexanediol, le diacrylate de 3-méthyl-1,5-pentanediol, le triacrylate de triméthylolpropane, et leurs mélanges, et peuvent être présents à raison notamment de 20 à 50 parties en volume par rapport au volume total de la composition.

Le ou les amorceurs thermiques peuvent être choisis parmi :
- les peroxydes, tels que le peroxybenzoate de tert-amyle, le peroxyde de benzoyle, le 2,2-bis(tert-butylperoxy)butane, le 1,1-bis(tert-butylperoxy)cyclohexane, le 2,5-bis(tert-butylperoxy)-2,5-diméthylhexane, le 2,5-bis(tert-butylperoxy)-2,5-diméthyl-3-hexyne, le bis(1-(tert-butylperoxy)-1-méthyl éthyl)benzène, le 1,1-bis(tert-butylperoxy)-3,3,5-triméthylcyclohexane, le peracétate de tert-butyle, le peroxyde de tert-butyle, le peroxybenzoate de tert-butyle, le carbonate de tert-butylperoxy isopropyle, le peroxyde de cyclohexanone, le peroxyde de dicumyle, le peroxyde de lauroyle, le peroxyde de 2,4-pentanedione, le persulfate de potassium et le persulfate d'ammonium;
- les hydroperoxydes, tels que l'hydroperoxyde de tert-butyle, l'hydroperoxyde de cumène et l'acide peracétique ;
- les alcoxyamines, telles que la N-(2-méthylpropyl)-N-(1-diéthylphosphono-2,2-diméthylpropyl)-O-(2-carboxyprop-2-yl)hydroxylamine (blocbuilder MA) ; et
- les composés azo, tels que le 1,1'-azobis (cyclohexanecarbonitrile) et le 2,2'-azobisisobutyronitrile (AIBN),
et peuvent être présents à raison notamment de 0,5 à 8 parties en volume par rapport au volume total de la composition.

La composition selon l'invention peut en outre comprendre au moins un plastifiant choisi notamment parmi le polyéthylène glycol, le phtalate de dibutyle, le glycérol, à raison notamment de 5 à 25 parties en volume par rapport au volume total de la composition.

La composition selon l'invention peut en outre comprendre au moins un dispersant choisi notamment parmi les esters phosphoriques, à raison notamment de 1 à 8 parties en volume par rapport au volume total de la composition.

La composition selon l'invention peut en outre comprendre au moins un inhibiteur de polymérisation choisi notamment parmi le 4-méthoxyphénol et la phénothiazine, à raison notamment de 0,1 à 3 parties en volume par rapport au volume total de la composition.

Les Exemples suivants illustrent la présente invention, sans toutefois en limiter la portée.

### Exemples 1 à 7

On a préparé des suspensions dont la composition est donnée dans les Tableaux suivants en % en volume du volume total et on a conduit des essais de stéréolithographie, aux longueurs d'onde, puissances et diamètres de faisceau également indiqués dans les tableaux. Ces expériences ont été réalisées avec une machine de stéréolithographie de type CERAMAKER équipée de différents lasers.

Les résultats figurent également dans chacun des Tableaux 1 à 2.

**[Table 1]**

| Ingrédients | Ex. 1 (comp.) | Ex. 2 (comp.) | Ex. 3 (de l'invention) | Ex. 4 (de l'invention) |
|---|---|---|---|---|
| Mélange LSM-8YSZ (lanthane strontium manganite - zircone stabilisée par l'yttrium) dans un rapport pondéral 50 :50 | 45 | 45 | 45 | 45 |
| Diacrylate de bisphénol A di-éthoxylé (Monomère) | 29 | 29 | 27 | 27 |
| 2-Hydroxy-2-méthyl-1-phényl-propane-1-one (Photoamorceur sensible à 355 nm) | 1 | 1 | 0 | 0 |
| Peroxyde de benzoyle à 50% en poids dans le tricrésylphosphate (Amorceur thermique) | 0 | 0 | 3 | 3 |
| Beycostat C 213 : ester phosphorique (Dispersant) | 5 | 5 | 5 | 5 |
| Polyéthylène glycol 300 (Plastifiant) | 19 | 19 | 19 | 19 |
| 4-Méthoxyphénol (Inhibiteur de polymérisation) | 1 | 1 | 1 | 1 |
| Longueur d'onde (nm) | 355 | 1064 | 1064 | 355 |
| Puissance (W) | 3 | 2 | 2 | 3 |
| Diamètre de faisceau (mm) | 4 | 4 | 4 | 4 |
| Résultat | Pas de réactivité | Pas de réactivité | Fabrication d'un objet de quelques centaines de µm de hauteur | Fabrication d'un objet de quelques centaines de µm de hauteur |

**[Table 2]**

| Ingrédients | Ex. 5 (comp.) | Ex. 6 (de l'invention) |
|---|---|---|
| Argent | 45 | 45 |
| Diacrylate de bisphénol A di-éthoxylé (Monomère) | 35 | 33 |
| 2-Hydroxy-2-méthyl-1-phényl-propane-1-one (Photoamorceur sensible à 355nm) | 2 | 0 |
| Peroxyde de benzoyle à 50% en poids dans le tricrésylphosphate (Amorceur thermique) | 0 | 3 |
| Beycostat C 213 : ester phosphorique (Dispersant) | 4 | 4 |
| Polyéthylène glycol 300 (Plastifiant) | 14 | 14 |
| 4-Méthoxyphénol (Inhibiteur de polymérisation) | 0 | 1 |
| Longueur d'onde (nm) | 355 | 355 |
| Puissance (W) | 3 | 3 |
| Diamètre de faisceau (mm) | 1 | 1 |
| | Réactivité très faible | Fabrication d'un objet de quelques centaines de µm de hauteur |

## Revendications

1. - Procédé de fabrication, par stéréolithographie, d'une pièce crue en un matériau céramique ou métallique, procédé suivant lequel des couches à base d'une composition durcissable comprenant :
- ledit matériau céramique ou métallique formé par au moins une poudre respectivement céramique ou métallique ; et
- une partie organique comprenant au moins un monomère et/ou un oligomère et au moins un amorceur de la polymérisation dudit ou desdits monomères et/ou oligomères,
sont amenées successivement à durcir par ladite polymérisation selon un motif défini pour chaque couche, la première couche étant formée sur une plate-forme de construction, et chaque autre couche étant formée puis amenée à durcir sur la couche précédente,
**caractérisé par le fait que** l'on utilise, comme amorceur(s), au moins un amorceur thermique, lequel est apte à générer l'amorçage d'une polymérisation thermique sous l'action de l'énergie thermique libérée par ledit matériau respectivement céramique ou métallique lors d'une insolation de celui-ci par au moins une source d'irradiation choisie parmi les sources d'irradiation UV, visible ou IR ;
la ou les poudres céramiques étant choisies parmi la céramique lanthane strontium manganite, la céramique lanthane strontium manganite en mélange avec de la zircone stabilisée par l'yttrium, la ferrite, le carbure de silicium et le nitrure de silicium, et la ou les poudres métalliques étant choisies parmi l'argent, le cuivre, le fer, le tungstène et leurs alliages.

2. - Procédé selon la revendication 1, **caractérisé par le fait que** l'on utilise 25 à 65 parties en volume de la ou les poudres céramiques et/ou métalliques par rapport au volume total.

3. - Procédé selon l'une des revendications 1 ou 2, **caractérisé par le fait que** l'on choisit le ou les monomères et/ou oligomères parmi les (méth)acrylates polyfonctionnels, comme le diméthacrylate de bisphénol A diéthoxylé, le diacrylate de 1,6-hexanediol, le diacrylate de 3-méthyl-1,5-pentanediol, le triacrylate de triméthylolpropane, et leurs mélanges, que l'on utilise à raison notamment de 20 à 50 parties en volume par rapport au volume total.

4. - Procédé selon l'une des revendications 1 à 3, **caractérisé par le fait que** l'on choisit le ou les amorceurs thermiques parmi :
- les peroxydes, tels que le peroxybenzoate de tert-amyle, le peroxyde de benzoyle, le 2,2-bis(tert-butylperoxy)butane, le 1,1-bis(tert-butylperoxy)cyclohexane, le 2,5-bis(tert-butylperoxy)-2,5-diméthylhexane, le 2,5-bis(tert-butylperoxy)-2,5-diméthyl-3-hexyne, le bis(1-(tert-butylperoxy)-1-méthyl éthyl)benzène, le 1,1-bis(tert-butylperoxy)-3,3,5-triméthylcyclohexane, le peracétate de tert-butyle, le peroxyde de tert-butyle, le peroxybenzoate de tert-butyle, le carbonate de tert-butylperoxy isopropyle, le peroxyde de cyclohexanone, le peroxyde de dicumyle, le peroxyde de lauroyle, le peroxyde de 2,4-pentanedione, le persulfate de potassium et le persulfate d'ammonium ;
- les hydroperoxydes, tels que l'hydroperoxyde de tert-butyle, l'hydroperoxyde de cumène et l'acide peracétique ;
- les alcoxyamines, telles que la N-(2-méthylpropyl)-N-(1-diéthylphosphono-2,2-diméthylpropyl)-0-(2-carboxyprop-2-yl)hydroxylamine (blocbuilder MA) ; et
- les composés azo, tels que le 1,1'-azobis (cyclohexanecarbonitrile) et le 2,2'-azobisisobutyronitrile (AIBN),
et l'on utilise le ou les amorceurs thermiques à raison notamment de 0,5 à 8 parties en volume par rapport au volume total.

5. - Procédé selon l'une des revendications 1 à 4, **caractérisé par le fait que** l'on utilise une composition durcissable comprenant en outre au moins un plastifiant choisi notamment parmi le polyéthylène glycol, le phtalate de dibutyle, le glycérol, à raison notamment de 5 à 25 parties en volume par rapport au volume total.

6. - Procédé selon l'une des revendications 1 à 5, **caractérisé par le fait que** l'on utilise une composition durcissable comprenant en outre au moins un dispersant choisi notamment parmi les esters phosphoriques, à raison notamment de 1 à 8 parties en volume par rapport au volume total.

7. - Procédé selon l'une des revendications 1 à 6, **caractérisé par le fait que** l'on utilise une composition durcissable comprenant en outre au moins un inhibiteur de polymérisation choisi notamment parmi le 4-méthoxyphénol et la phénothiazine, à raison notamment de 0,1 à 3 parties en volume par rapport au volume total.

8. - Composition durcissable pour la mise en oeuvre du procédé selon l'une des revendications 1 à 7, **caractérisée par le fait qu'**elle comporte :
- une ou des poudres céramiques et/ou métalliques, la ou les poudres céramiques étant choisies parmi la céramique lanthane strontium manganite, la céramique lanthane strontium manganite en mélange avec de la zircone stabilisée par l'yttrium, la ferrite, le carbure de silicium et le nitrure de silicium, et la ou les poudres métalliques étant choisies parmi l'argent, le cuivre, le fer, le tungstène et leurs alliages ;
- un ou des monomères et/ou oligomères, et
- au moins un amorceur thermique, apte à générer l'amorçage d'une polymérisation thermique sous l'action de l'énergie thermique libérée par ledit matériau respectivement céramique ou métallique lors d'une insolation de celui-ci par au moins une source d'irradiation choisie parmi les sources d'irradiation UV, visible ou IR.

9. - Composition selon la revendication 8, **caractérisée par le fait que** la ou les poudres céramiques et/ou métalliques sont présentes à raison notamment 25 à 65 parties en volume par rapport au volume total de la composition.

10. - Composition selon l'une des revendications 8 ou 9, **caractérisée par le fait que** le ou les monomères et/ou oligomères sont choisis parmi les (méth)acrylates polyfonctionnels, comme le diméthacrylate de bisphénol A diéthoxylé, le diacrylate de 1,6-hexanediol, le diacrylate de 3-méthyl-1,5-pentanediol, le triacrylate de triméthylolpropane, et leurs mélanges, et sont présents à raison notamment de 20 à 50 parties en volume par rapport au volume total de la composition.

11. - Composition selon l'une des revendications 8 à 10, **caractérisée par le fait que** le ou les amorceurs thermiques sont choisis parmi :
- les peroxydes, tels que le peroxybenzoate de tert-amyle, le peroxyde de benzoyle, le 2,2-bis(tert-butylperoxy)butane, le 1,1-bis(tert-butylperoxy)cyclohexane, le 2,5-bis(tert-butylperoxy)-2,5-diméthylhexane, le 2,5-bis(tert-butylperoxy)-2,5-diméthyl-3-hexyne, le bis(1-(tert-butylperoxy)-1-méthyl éthyl)benzène, le 1,1-bis(tert-butylperoxy)-3,3,5-triméthylcyclohexane, le peracétate de tert-butyle, le peroxyde de tert-butyle, le peroxybenzoate de tert-butyle, le carbonate de tert-butylperoxy isopropyle, le peroxyde de cyclohexanone, le peroxyde de dicumyle, le peroxyde de lauroyle, le peroxyde de 2,4-pentanedione, le persulfate de potassium et le persulfate d'ammonium ;
- les hydroperoxydes, tels que l'hydroperoxyde de tert-butyle, l'hydroperoxyde de cumène et l'acide peracétique ;
- les alcoxyamines, telles que la N-(2-méthylpropyl)-N-(1-diéthylphosphono-2,2-diméthylpropyl)-0-(2-carboxyprop-2-yl)hydroxylamine (blocbuilder MA) ; et
- les composés azo, tels que le 1,1'-azobis (cyclohexanecarbonitrile) et le 2,2'-azobisisobutyronitrile (AIBN),
et sont présents à raison notamment de 0,5 à 8 parties en volume par rapport au volume total de la composition.

12. - Composition selon l'une des revendications 8 à 11, **caractérisée par le fait qu'**elle comprend en outre au moins un plastifiant choisi notamment parmi le polyéthylène glycol, le phtalate de dibutyle, le glycérol, à raison notamment de 5 à 25 parties en volume par rapport au volume total de la composition.

13. - Composition selon l'une des revendications 8 à 12, **caractérisée par le fait qu'**elle comprend en outre au moins un dispersant choisi notamment parmi les esters phosphoriques, à raison notamment de 1 à 8 parties en volume par rapport au volume total de la composition.

14. - Composition selon l'une des revendications 8 à 13, **caractérisée par le fait qu'**elle comprend en outre au moins un inhibiteur de polymérisation choisi notamment parmi le 4-méthoxyphénol et la phénothiazine, à raison notamment de 0,1 à 3 parties en volume par rapport au volume total de la composition.

## Patentansprüche

1. - Verfahren zur Herstellung, durch Stereolithographie, eines keramischen oder metallischen Grünkörpers, Verfahren, gemäß dem die Basisschichten einer härtbaren Zusammensetzung, umfassend:
- das keramische oder metallische Material, gebildet aus mindestens einem keramischen bzw. metallischen Pulver; und
- einen organischen Teil, umfassend mindestens ein Monomer und/oder ein Oligomer und mindestens einen Initiator der Polymerisation des oder der Monomere und/oder Oligomere
aufeinanderfolgend zum Aushärten durch die Polymerisation gemäß einem Muster gebracht werden, das für jede Schicht definiert wird, wobei die erste Schicht auf einer Konstruktionsplattform gebildet wird, und wobei jede andere Schicht gebildet und dann zum Aushärten auf der vorhergehenden Schicht gebracht wird,
**dadurch gekennzeichnet, dass**, als Initiator(en), mindestens ein thermischer Initiator verwendet wird, der dazu in der Lage ist, die Initiierung einer thermischen Polymerisation unter der Einwirkung thermischer Energie zu erzeugen, die von dem keramischen bzw. metallischen Material bei einer Bestrahlung desselben durch mindestens eine Strahlungsquelle, ausgewählt aus den Strahlungsquellen UV, sichtbar oder IR, freigesetzt wird;
wobei das oder die keramische(n) Pulver ausgewählt ist/sind aus der Keramik Lanthan-Strontium-Manganit, der Keramik Lanthan-Strontium-Manganit in Mischung mit Zirkoniumoxid, stabilisiert durch Yttrium, Ferrit, Siliziumkarbid und Siliziumnitrid, und wobei das oder die metallischen Pulver ausgewählt ist/sind aus Silber, Kupfer, Eisen, Wolfram und ihren Legierungen.

2. - Verfahren nach Anspruch 1, **dadurch gekennzeichnet, dass** 25 bis 65 Volumenteile des oder der keramischen und/oder metallische Pulver(s) mit Bezug auf das Gesamtvolumen verwendet werden.

3. - Verfahren nach einem der Ansprüche 1 oder 2, **dadurch gekennzeichnet, dass** das oder die Monomer(e) und/oder Oligomer(e) aus den polyfunktionalen (Meth)acrylaten wie dem diethoxylierten Bisphenol-A-dimethacrylat, dem 1,6-Hexandioldiacrylat, dem 3-Methyl-1,5-pentandioldiacrylat, dem Trimethylolpropantriacrylat und ihren Mischungen ausgewählt ist/sind, die in einer Menge insbesondere von 20 bis 50 Volumenteilen mit Bezug auf das Gesamtvolumen verwendet werden.

4. - Verfahren nach einem der Ansprüche 1 bis 3, **dadurch gekennzeichnet, dass** der oder die thermischen Initiator(en) ausgewählt ist/sind aus:
- den Peroxiden wie dem tert-Amylperoxybenzoat, dem Benzoylperoxid, dem 2,2-bis(tert-Butylperoxy)butan, dem 1,1-bis(tert-Butylperoxy)cyclohexan, dem 2,5-bis(tert-Butylperoxy)-2,5-dimethylhexan, dem 2,5-bis(tert-Butylperoxy)-2,5-dimethyl-3-hexin, dem bis(1-(tert-Butylperoxy)-1-methylethyl)benzen, dem 1,1-bis(tert-Butylperoxy)-3,3,5-trimethylcyclohexan, dem tert-Butylperacetat, dem tert-Butylperoxid, dem tert-Butylperoxybenzoat, dem tert-Butylperoxyisopropylcarbonat, dem Cyclohexanonperoxid, dem Dicumylperoxid, dem Lauroylperoxid, dem 2,4-Pentandionperoxid, dem Kaliumpersulfat und dem Ammoniumpersulfat;
- den Hydroperoxiden wie dem tert-Butylhydroperoxid, dem Cumenhydroperoxid und der Peressigsäure;
- den Alcoxyaminen wie dem N-(2-Methylpropyl)-N-(1-diethylphosphono-2,2-dimethylpropyl)-O-(2-carboxyprop-2-yl)hydroxylamin (Blocbuilder MA); und
- den Azo-Zusammensetzungen wie dem 1,1'-Azobis(cyclohexancarbonitril) und dem 2,2'-Azobisisobutyronitril (AIBN) ausgewählt werden
und der oder die thermischen Initiator (en) in einer Menge insbesondere von 0,5 bis 8 Volumenteilen mit Bezug auf das Gesamtvolumen verwendet werden.

5. - Verfahren nach einem der Ansprüche 1 bis 4, **dadurch gekennzeichnet, dass** eine härtbare Zusammensetzung, umfassend außerdem mindestens einen Weichmacher, ausgewählt insbesondere aus dem Polyethylenglycol, dem Dibutylphthalat, dem Glycerol, in einer Menge insbesondere von 5 bis 25 Volumenteilen mit Bezug auf das Gesamtvolumen verwendet wird.

6. - Verfahren nach einem der Ansprüche 1 bis 5, **dadurch gekennzeichnet, dass** eine härtbare Zusammensetzung, umfassend außerdem mindestens ein Dispergiermittel, ausgewählt insbesondere aus den Phosphorestern, in einer Menge insbesondere von 1 bis 8 Volumenteilen mit Bezug auf das Gesamtvolumen verwendet wird.

7. - Verfahren nach einem der Ansprüche 1 bis 6, **dadurch gekennzeichnet, dass** eine härtbare Zusammensetzung, umfassend außerdem mindestens einen Polymerisationshemmer, ausgewählt insbesondere aus dem 4-Methoxyphenol und dem Phenothiazin, in einer Menge insbesondere von 0,1 bis 3 Volumenteilen mit Bezug auf das Gesamtvolumen verwendet wird.

8. - Härtbare Zusammensetzung für die Durchführung des Verfahrens nach einem der Ansprüche 1 bis 7, **dadurch gekennzeichnet, dass** sie Folgendes umfasst:
- ein oder mehrere keramische und/oder metallische Pulver, wobei das oder die keramischen Pulver ausgewählt sind aus der Keramik Lanthan-Strontium-Manganit, der Keramik Lanthan-Strontium-Manganit im Mischung mit Zirkoniumoxid, stabilisiert durch Yttrium, Ferrit, Siliziumkarbid und Siliziumnitrid, und wobei das oder die metallischen Pulver ausgewählt sind aus Silber, Kupfer, Eisen, Wolfram und ihren Legierungen;
- ein oder mehrere Monomere und/oder Oligomere, und
- mindestens einen thermischen Initiator, der ausgelegt ist, um die Initiierung einer thermischen Polymerisation unter der Einwirkung der thermischen Energie zu erzeugen, die von dem keramischen bzw. metallischen Material bei einer Bestrahlung desselben durch mindestens eine Strahlungsquelle, ausgewählt aus den Strahlungsquellen UV, sichtbar oder IR, freigesetzt wird.

9. - Zusammensetzung nach Anspruch 8, **dadurch gekennzeichnet, dass** das oder die keramische(n) und/oder metallische(n) Pulver in einer Menge insbesondere von 25 bis 65 Volumenteilen mit Bezug auf das Gesamtvolumen der Zusammensetzung vorhanden ist/sind.

10. - Zusammensetzung nach einem der Ansprüche 8 oder 9, **dadurch gekennzeichnet, dass** das oder die Monomer(e) und/oder Oligomer(e) ausgewählt ist/sind aus den polyfunktionalen (Meth)acrylaten wie dem diethoxylierten Bisphenol-A-dimethacrylat, dem 1,6-Hexandioldiacrylat, dem 3-Methyl-1,5-Pentandioldiacrylat, dem Trimethylolpropantriacrylat und ihren Mischungen, und in einer Menge insbesondere von 20 bis 50 Volumenteilen mit Bezug auf das Gesamtvolumen der Zusammensetzung vorhanden ist/sind.

11. - Zusammensetzung nach einem der Ansprüche 8 bis 10, **dadurch gekennzeichnet, dass** der oder die thermischen Initiator(en) ausgewählt sind aus:
- den Peroxiden wie dem tert-Amylperoxybenzoat, dem Benzoylperoxid, dem 2,2-bis(tert-Butylperoxy)butan, dem 1,1-bis(tert-Butylperoxy)cyclohexan, dem 2,5-bis(tert-Butylperoxy)-2,5-dimethylhexan, dem 2,5-bis(tert-Butylperoxy)-2,5-dimethyl-3-hexin, dem bis(1-(tert-Butylperoxy)-1-methylethyl)benzen, dem 1,1-bis(tert-Butylperoxy)-3,3,5-trimethylcyclohexan, dem tert-Butylperacetat, dem tert-Butylperoxid, dem tert-Butylperoxybenzoat, dem tert-Butylperoxyisopropylcarbonat, dem Cyclohexanonperoxid, dem Dicumylperoxid, dem Lauroylperoxid, dem 2,4-Pentandionperoxid, dem Kaliumpersulfat und dem Ammoniumpersulfat;
- den Hydroperoxiden wie dem tert-Butylhydroperoxid, dem Cumenhydroperoxid und der Peressigsäure;
- den Alcoxyaminen wie dem N-(2-Methylpropyl)-N-(1-diethylphosphono-2,2-dimethylpropyl)-O-(2-carboxyprop-2-yl)hydroxylamin (Blocbuilder MA); und
- den Azo-Zusammensetzungen wie dem 1,1'-Azobis(cyclohexancarbonitril) und dem 2,2'-Azobisisobutyronitril (AIBN),
und in einer Menge insbesondere von 0,5 bis 8 Volumenteilen mit Bezug auf das Gesamtvolumen der Zusammensetzung vorhanden sind.

12. - Zusammensetzung nach einem der Ansprüche 8 bis 11, **dadurch gekennzeichnet, dass** sie außerdem mindestens einen Weichmacher umfasst, ausgewählt insbesondere aus dem Polyethylenglycol, dem Dibutylphtalat, dem Glycerol in einer Menge insbesondere von 5 bis 25 Volumenteilen mit Bezug auf das Gesamtvolumen der Zusammensetzung.

13. - Zusammensetzung nach einem der Ansprüche 8 bis 12, **dadurch gekennzeichnet, dass** sie außerdem mindestens ein Dispergiermittel umfasst, ausgewählt insbesondere aus den Phosphorestern, in einer Menge insbesondere von 1 bis 8 Volumenteilen mit Bezug auf das Gesamtvolumen der Zusammensetzung.

14. - Zusammensetzung nach einem der Ansprüche 8 bis 13, **dadurch gekennzeichnet, dass** sie mindestens einen Polymerisationshemmer umfasst, ausgewählt insbesondere aus dem 4-Methoxyphenol und dem Phenothiazin, in einer Menge insbesondere von 0,1 bis 3 Volumenteilen mit Bezug auf das Gesamtvolumen der Zusammensetzung.

## Claims

1. - Method for manufacturing by stereolithography a green part made of a ceramic or metallic material, method according to which layers based on a curable composition comprising:
- said ceramic or metallic material formed by at least a ceramic or metallic powder respectively; and
- an organic part comprising at least one monomer and/or one oligomer and at least one initiator for the polymerization of said monomer(s) and/or oligomer(s),
are successively cured by said polymerization according to a pattern defined for each layer, the first layer being formed on a construction platform, and each other layer being formed then cured on the preceding layer,
**characterized in that** as initiator(s), at least one thermal initiator is used, the at least one thermal initiator being capable of generating the initiation of a thermal polymerization under the action of the thermal energy released by said ceramic or metallic material respectively, during exposure of the latter to at least one irradiation source chosen from an UV irradiation source, a visible irradiation source and an IR irradiation source;
the ceramic powder(s) being chosen among lanthanum strontium manganite ceramic, lanthanum strontium manganite ceramic in mixture with yttrium-stabilized zirconia, ferrite, silicon carbide, and silicon nitride, and the metallic powder(s) being chosen among silver, copper, iron, tungsten and their alloys.

2. - Method according to claim 1, **characterized in that** 25 to 65 parts by volume of the ceramic and/or metallic powder(s) relative to the total volume is used.

3. - Method according one of claims 1 or 2, **characterized in that** the monomer(s) and/or oligomer(s) are chosen among polyfunctional (meth)acrylates, such as diethoxylated bisphenol A dimethacrylate, 1,6-hexanediol diacrylate, 3-methyl-1,5-pentanediol diacrylate, trimethylolpropane triacrylate, and mixtures thereof, that are used at a rate of, in particular, 20 to 50 parts by volume relative to the total volume.

4. - Method according to one of claims 1 to 3, **characterized in that** the thermal initiator(s) are chosen among:
- peroxides, such as tert-amyl peroxybenzoate, benzoyl peroxide, 2,2-bis(tert-butylperoxy)butane, 1,1-bis(tert-butylperoxy)cyclohexane, 2,5-bis(tert-butylperoxy)-2,5-dimethylhexane, 2,5-bis(tert-butylperoxy)-2,5-dimethyl-3-hexyne, bis(1-(tert-butylperoxy)-1-methyl ethyl)benzene, 1,1-bis(tert-butylperoxy)-3,3,5-trimethylcyclohexane, tert-butyl peracetate, tert-butyl peroxide, tert-butyl peroxybenzoate, tert-butylperoxy isopropyl carbonate, cyclohexanone peroxide, dicumyl peroxide, lauroyl peroxide, 2,4-pentanedione peroxide, potassium persulfate and ammonium persulfate;
- hydroperoxides, such as tert-butyl hydroperoxide, cumene hydroperoxide and peracetic acid;
- alkoxyamines, such as N-(2-methylpropyl)-N-(1-diethylphosphono-2,2-dimethylpropyl)-O-(2-carboxyprop-2-yl)hydroxylamine (blocbuilder MA); and
- azo compounds, such as 1,1'-azobis(cyclohexanecarbonitrile) and 2,2'-azobisisobutyronitrile (AIBN),
and the thermal initiator (s) are used at a rate of, in particular, 0.5 to 8 parts by volume relative to the total volume.

5. - Method according to one of claims 1 to 4, charaterized in that a curable composition further comprising at least one plasticizer chosen, in particular, from polyethylene glycol, dibutyl phthalate, glycerol, in particular at a rate of 5 to 25 parts by volume relative to the total volume, is used.

6. - Method according to one of claims 1 to 5, **characterized in that** a curable composition further comprising at least one dispersant chosen, in particular, from phosphoric esters, in particular at a rate of 1 to 8 parts by volume relative to the total volume, is used.

7. - Method according to one of claims 1 to 6, **characterized in that** a curable composition further comprising at least one polymerization inhibitor chosen, in particular, from 4-methoxyphenol and phenothiazine, in particular at a rate of 0.1 to 3 parts by volume relative to the total volume, is used.

8. - Curable composition for implementing the method according to one of claims 1 to 7, **characterized in that** it comprises:
- one or more ceramic and/or metallic powders, the ceramic powder(s) being chosen among lanthanum strontium manganite ceramic, lanthanum strontium manganite ceramic in mixture with yttrium-stabilized zirconia, ferrite, silicon carbide, and silicon nitride, and the metallic powder(s) being chosen among silver, copper, iron, tungsten, and their alloys;
- one or more monomer(s) and/or oligomer(s), and
- at least one thermal initiator, capable of generating the initiation of a thermal polymerization under the action of the thermal energy released by said ceramic or metallic material respectively, during exposure of the latter to at least one irradiation source chosen from an UV irradiation source, a visible irradiation source and an IR irradiation source.

9. - Composition according to claim 8, **characterized in that** the ceramic and/or metallic powder(s) are present in particular at a rate of 25 to 65 parts by volume relative to the total volume of the composition.

10. - Composition according to one of claims 8 or 9, **characterized in that** the monomer(s) and/or oligomer(s) are chosen among polyfunctional (meth)acrylates, such as diethoxylated bisphenol A dimethacrylate, 1,6-hexanediol diacrylate, 3-methyl-1,5-pentanediol diacrylate, trimethylolpropane triacrylate, and mixtures thereof, and are present in particular at a rate of 20 to 50 parts by volume relative to the total volume of the composition.

11. - Composition according to one of claim 8 to 10, **characterized in that** the thermal initiator(s) are chosen from:
- peroxides, such as tert-amyl peroxybenzoate, benzoyl peroxide, 2,2-bis(tert-butylperoxy)butane, 1,1-bis(tert-butylperoxy)cyclohexane, 2,5-bis(tert-butylperoxy)-2,5-dimethylhexane, 2,5-bis(tert-butylperoxy)-2,5-dimethyl-3-hexyne, bis(1-(tert-butylperoxy)-1-methyl ethyl)benzene, 1,1-bis(tert-butylperoxy)-3,3,5-trimethylcyclohexane, tert-butyl peracetate, tert-butyl peroxide, tert-butyl peroxybenzoate, tert-butylperoxy isopropyl carbonate, cyclohexanone peroxide, dicumyl peroxide, lauroyl peroxide, 2,4-pentanedione peroxide, potassium persulfate and ammonium persulfate;
- hydroperoxides, such as tert-butyl hydroperoxide, cumene hydroperoxide and peracetic acid;
- alkoxyamines, such as N-(2-methylpropyl)-N-(1-diethylphosphono-2,2-dimethylpropyl)-O-(2-carboxyprop-2-yl)hydroxylamine (blocbuilder MA); and
- azo compounds, such as 1,1'-azobis(cyclohexanecarbonitrile) and 2,2'-azobisisobutyronitrile (AIBN),
and are present in particular at a rate of 0.5 to 8 parts by volume relative to the total volume.

12. - Composition according to one of claim 8 to 11, **characterized in that** it further comprises at least one plasticizer chosen, in particular, from polyethylene glycol, dibutyl phthalate, glycerol, in particular at a rate of 5 to 25 parts by volume relative to the total volume of the composition.

13. - Composition according to one of claims 8 to 12, **characterized in that** it further comprises at least one dispersant chosen, in particular, from phosphoric esters, in particular at a rate of 1 to 8 parts by volume relative to the total volume of the composition.

14. - Composition according to one of claims 8 to 13, characterized it further comprises at least one polymerization inhibitor chosen, in particular, from 4-methoxyphenol and phenothiazine, in particular at a rate of 0.1 to 3 parts by volume relative to the total volume.
